# EUROPEAN PATENT APPLICATION

(11) **EP 4 243 104 A1**
(43) Date of publication of application: **13.09.2023**
(21) Application number: 21889428.5
(22) Date of filing: 19.10.2021
(51) Int. Cl.: H01L 51/44, H01L 51/42, C09C 3/08, C09D 5/02, B82Y 40/00

(54) **COATING AGENT FOR ELECTRON TRANSFER LAYER OF INVERTED PEROVSKITE SOLAR CELL, AND INVERTED PEROVSKITE SOLAR CELL**

(30) Priority: 09.11.2020 KR 20200148473
(71) Applicant: Hanwha Solutions Corporation, Jung-gu Seoul 04541 (KR)
(72) Inventor: YEOM, Eun Joo, Guri-si, Gyeonggi-do 11919 (KR); JUNG, Kwang Ho, Uiwang-si, Gyeonggi-do 16021 (KR)
(74) Representative: Mooser, Sebastian Thomas
(86) International application number: PCT/KR2021/014538
(87) International publication number: WO 2022/097963

(57) **Abstract**

The present invention relates to an inverted perovskite prepared by providing a surface-modified metal oxide nanoparticle as a coating agent for forming an electron transporting layer (or electron transport layer), and using the surface-modified metal oxide nanoparticle as a coating agent prepared in a dispersion type.

## Description

### TECHNICAL FIELD

The present invention relates to a coating agent for forming an electron transporting layer of a solar cell and an inverted perovskite solar cell including an electron transporting layer formed using the coating agent.

### BACKGROUND

In order to solve the global environmental problems caused by the depletion of fossil energy and its use, research on renewable and clean alternative energy sources such as solar energy, wind power, and hydroelectric power is being actively conducted.

Among them, interest in solar cells that convert sunlight directly into electrical energy is greatly increasing. Here, the solar cell refers to a cell that generates current-voltage using the photovoltaic effect of generating electrons and holes by absorbing light energy from sunlight.

Currently, it is possible to manufacture n-p diode-type si licon (Si) single crystal-based solar cells with a light energy conversion efficiency of over 20% and it is used in actual solar power generation, and there is also a solar cell using a compound semiconductor such as gallium arsenide (GaAs), which has a higher conversion efficiency than this. However, since these inorganic semiconductor-based solar cells require highly purified materials for high efficiency, a lot of energy is consumed in refining raw materials, and also, expensive process equipment is required in the process of single crystal or thin film using raw materials, so there is a limit to lowering the manufacturing cost of solar cells, which has been an obstacle to large-scale utilization.

Accordingly, in order to manufacture a solar cell at low costs, a cost of a material used as a core for a solar cell or a manufacturing process needs to be greatly reduced, and as an alternative to an inorganic semiconductor-based solar cell, research on a perovskite solar cell that can be manufactured by a low-cost material and process has been conducted.

Recently, a perovskite solar cell using (NH₃CH₃)PbX₃ (X=I, Br, Cl) which is a halogen compound having a perovskite structure as a photoactive material has been developed, and research on commercialization has been conducted. The general structural formula of the perovskite structure is an ABX₃ structure, where an anion is located at the X position, a large cation is located at the A position, and a small cation is located at the B position.

The perovskite solar cell, which is an organometallic halogen compound of the molecular formula (CH₃NH₃)PbX₃, was first used as a photoactive material of a solar cell in 2009. Since the solid-type perovskite solar cell having the structure as present in 2012 has been developed, efficiency has been rapidly improved. Typical perovskite solar cells use a metal oxide as an electron transporting layer and mainly use an organic material or a polymer material such as spiro-OMETAD as a hole transport layer (HTL). That is, a metal oxide porous film or thin film is manufactured on a transparent electrode such as FTO, and a perovskite material is coated, and then, a hole transport layer is coated, and an electrode layer such as gold (Au) or silver (Ag) is deposited.

An important task for commercialization of a perovskite solar cell is stability securing and flexible technology, and the existing electron transporting layer formed using a metal oxide on the photoactive layer has a metal oxide deposition layer or a metal oxide coating layer on the photoactive layer (or the light absorption layer), and then a separate organic binder coating layer is formed thereon. However, there are disadvantages in that when a metal oxide is deposited and formed, a manufacturing process is complicated to greatly increase manufacturing costs, and a light absorption layer may be damaged due to physical and chemical energy generated during the deposition process. In addition, in the method of forming the organic binder coating layer, there is a problem in that high-temperature heat treatment is performed to form the coating layer, but the perovskite material is decomposed at a high temperature of 200 °C or higher, and there is a problem of reducing the flexibility of the solar cell and narrowing the application range of the perovskite solar cell.

### SUMMARY

### Technical Problem

The present invention has been devised in an effort to solve the problems described above, and is directed to providing an inverted perovskite prepared by providing a surface-modified metal oxide nanoparticle as a coating agent for forming an electron transporting layer (or electron transport layer, ETL), and using the surface-modified metal oxide nanoparticle as a coating agent prepared in a dispersion type.

### Technical Solution

In order to solve the above problems, the present invention relates to a coating agent for an electron transporting layer of an inverted perovskite solar cell, and includes a dispersion in which a surface-modified metal oxide is dispersed in an organic solvent.

In a preferred embodiment of the present invention, the coating agent for the electron transporting layer of the present invention may include 0.50 wt % to 3.00 wt % of the surface-modified metal oxide and a remaining amount of an organic solvent.

In a preferred embodiment of the present invention, the dielectric constant of the organic solvent may be 20 or less.

In a preferred embodiment of the present invention, the organic solvent may include at least one selected from isopropyl alcohol, butyl alcohol, 2-methoxy ethanol, and ethyl acetate.

In a preferred embodiment of the present invention, the surface-modified metal oxide may be surface-modified by reacting metal oxide nanoparticles with a compound represented by the following Formula 1: 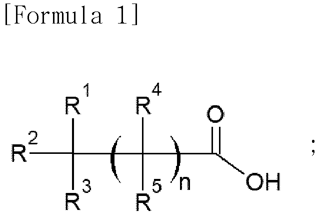 wherein R¹ to R⁵ in Formula 1 are independently a hydrogen atom or a halogen atom, and n is 0 to 5.

In a preferred embodiment of the present invention, the metal oxide nanoparticles may include a metal oxide comprising one or two or more selected from tin (Sn), zirconium (Zr), strontium (Sr), zinc (Zn), vanadium (V), molybdenum (Mo), tungsten (W), niobium (Nb), aluminum (Al), and gallium (Ga).

In a preferred embodiment of the present invention, the metal oxide nanoparticles may have an average particle diameter of 2 to 10 nm.

Another object of the present invention is directed to providing an electron transporting layer of an inverted perovskite solar cell, including a coating layer formed of the coating agent for the electron transporting layer described above.

In a preferred embodiment of the present invention, the coating layer may have a transmittance of 88 to 95% for a wavelength of 500 to 550 nm when the coating layer has a thickness of 20 to 30 nm.

Another object of the present invention is directed to providing an inverted perovskite solar cell including the electron transporting layer.

In a preferred embodiment of the present invention, the inverted perovskite solar cell may include a structure in which a conductive substrate, a drain electrode, a hole transport layer, a light absorption layer, an electron transporting layer, and a source electrode are sequentially stacked.

In a preferred embodiment of the present invention, the inverted perovskite solar cell may further include a passivation layer between the light absorption layer and the electron transporting layer.

### Advantageous Effects

Since the coating agent for an electron transporting layer of the present invention can form an ultra-thin film having a thickness of 1 to 20 nm through a low-temperature heat treatment of 200 °C or less without a high-temperature treatment process for forming a thin film, damage to the perovskite light absorption layer can be prevented, and since the electron transporting layer formed with the coating solution of the present invention has a high uniformity of a thin film, the solar cell has excellent V_{oc} (open-circuit voltage) and FF (fill factor), and has excellent J_{sc} (short-circuit current) due to a high light transmittance, thereby manufacturing a solar cell with excellent photo-electric conversion efficiency.

### BRIEF DESCRIPTION OF THE DRAWINGS

FIG. 1 is a TEM measurement image of SnO₂ nanoparticles prepared in Example 1.
FIG. 2 is a XRD measurement graph of SnO₂ nanoparticles prepared in Example 1.
FIG. 3 is a FT-IR measurement graph of surface-modified SnO₂ nanoparticles prepared in Example 1.
FIG. 4(a) is a photograph of a solution in which unmodified SnO₂ nanoparticles are dispersed in isopropanol, and FIG. 4(b) is a photograph of a coating solution for forming an electron transporting layer prepared in Example 1.
FIG. 5 is a result of measuring a transmittance of a thin film prepared using the coating solution for forming an electron transporting layer of Example 1.
FIG. 6 is a SEM measurement image of a cross-section and a structural diagram of an inverted perovskite solar cell prepared in Preparing Example 1.
FIG. 7 is a result of measuring a current density of an inverted perovskite solar cell prepared in Preparing Example 1.

### DETAILED DESCRIPTION OF THE EMBODIMENTS

Hereinafter, the present invention will be described in more detail.

The present invention relates to a coating agent for forming an electron transporting layer (or electron transport layer, ETL) of an inverted perovskite solar cell, and includes a dispersion in which surface-modified metal oxide nanoparticles are dispersed in an organic solvent.

The coating agent of the present invention comprises 0.50 to 3.00% by weight of the surface-modified metal oxide and a balance of an organic solvent based on the total weight, preferably 0.58 to 2.88% by weight of the surface-modified metal oxide and a balance of an organic solvent, more preferably 0.65 to 1.91% by weight of the surface-modified metal oxide and a balance of an organic solvent.

In this case, if the content of the surface-modified metal oxide in the coating agent is less than 0.50 wt %, the content of the SnO₂ is not sufficient, and thus the light absorption layer may be exposed during the formation of the SnO₂ thin film, and if the content of the surface-modified metal oxide in the coating agent exceeds 3.00 wt %, the thickness of the SnO₂ thin film increases, and thus the short-circuit current (Jsc) and open-circuit voltage (Voc) values of the solar cell may decrease, and thus, it is preferable to include a surface-modified metal oxide within the above range.

In addition, the organic solvent may have a dielectric constant of 20 or less, preferably 5 to 15. Specific examples of the organic solvent include isopropyl alcohol, butyl alcohol, 2-methoxy ethanol, ethyl acetate, and the like, and may be used alone or in combination as the organic solvent of the present invention. If a solvent having a dielectric constant higher than 20, the attractive force between the SnO₂ particles and the polar solvent may be increased, thereby causing the SnO₂ particles to agglomerate (degrading dispersibility and dispersion stability), and in the process of forming the SnO₂ thin film, the perovskite material, which is the light absorption layer, may be decomposed in the polar solvent.

The surface-modified metal oxide nanoparticles may be prepared by performing a process including a first step of preparing metal oxide nanoparticles and a second step of react ing the metal oxide with a compound represented by the following Formula 1 to prepare surface-modified metal oxide nanoparticles. 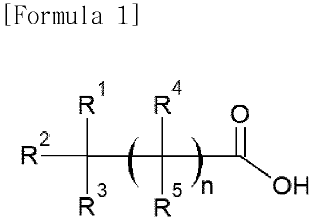 In Formula 1, R1 to R5 are independently a hydrogen atom or a halogen atom, preferably a halogen atom, and more preferably -F. And, n is 0 to 5, preferably 0 to 3, and more preferably 0 to 2.

More specifically, the first step may be prepared by performing a process including the steps of: first-1 mixing a metal precursor and ultrapure water to prepare a metal precursor solution; first-2 adding a basic aqueous solution to the metal precursor solution to prepare a reaction solution; and first-3 performing hydrothermal synthesis on the reaction solution and obtaining metal oxide nanoparticles from the hydrothermal synthesis product.

The metal precursor solution of step first-1 may include a metal precursor and ultrapure water, and the concentration of the metal precursor in the metal precursor solution may be 0.15 to 0.7 M, preferably 0.16 to 0.5 M. In this case, if the metal precursor concentration in the metal precursor solution is less than 0.15 M, the metal oxide nanoparticle yield may be too small, and when the metal precursor concentration in the metal precursor solution is greater than 0.7 M, the viscosity of the metal precursor aqueous solution increases, and thus, there may be a problem in that the metal oxide nanoparticles are unevenly formed when prepared under the same process conditions, and thus uniform nanoparticles cannot be obtained.

The basic aqueous solution of step first-2 may include at least one selected from a KOH aqueous solution, a NaOH aqueous solution, a hydrazine aqueous solution, and a NH₄OH aqueous solution. In addition, the amount of the basic aqueous solution used is added to the metal precursor solution such that the pH of the reaction solution is about 8.0 or higher, preferably about 8.0 to 9.0, and more preferably about 8.2 to 8.8, and in this case, when the pH is less than 8, the metal oxide nanoparticle yield may be too small, and further, the metal precursor solution may be gelled and stirring may not be good, and when the pH is too high, the particle diameter of the metal oxide particles may be too large.

The hydrothermal synthesis of step first-3 may be performed by applying a general hydrothermal synthesis method used in the art, and the hydrothermal synthesis may be performed at 100 to 200°C, preferably at 120 to 190°C, and more preferably at 140 to 180 °C for 6 to 48 hours, preferably 10 to 24 hours, and more preferably 12 to 18 hours. In this case, if the hydrothermal synthesis temperature is less than 100 °C, the crystallinity of the metal oxide may be low, and if the temperature is more than 200°C, the size of the metal oxide particles may be increased. In addition, if the hydrothermal synthesis time is less than 6 hours, the yield of the metal oxide nanoparticles may be too deteriorated, and if the time is more than 48 hours, the size of the hydrothermal synthesis product may be too large, and thus, the hydrothermal synthesis may be performed within the above time.

The metal oxide nanoparticles obtained through the hydrothermal synthesis may be repeatedly washed 3 to 5 times using ultrapure water and ethanol.

The metal oxide nanoparticles obtained in this way may have an average particle diameter of 2 to 10 nm, preferably an average particle diameter of 2 to 8 nm, and more preferably an average particle diameter of 3 to 5 nm.

And, the metal oxide of the metal oxide nanoparticles may be an oxide of a metal including one or two or more selected from tin (Sn), titanium (Ti), zinc (Zn), cerium (Ce), zirconium (Zr), strontium (Sr), zinc (Zn), vanadium (V), molybdenum (Mo), tungsten (W), niobium (Nb), aluminum (Al), and gallium (Ga), and in one embodiment, the metal oxide may include SnO₂, TiO₂, ZnO, CeO₂ and/or Zn₂SnO₄, and the like, and preferably may include SnO₂ and/or ZnO.

Next, the second step may perform a process of modifying the surface of the metal oxide nanoparticles obtained in the first step, the process including the steps of: second-1 mixing the metal oxide nanoparticles and ultrapure water to prepare a solution; second-2 adding the compound represented by Formula 1 to the solution to prepare a reaction solution; second-3 performing a reflux reaction of the reaction solution; second-4 separating a reaction product from the solution subjected to the reflux reaction and washing the separated reaction product; and second-5 drying the washed reaction product to obtain surface-modified metal oxide nanoparticles.

The reaction solution may include 100 to 700 parts by weight of ultrapure water and 300 to 1,500 parts by weight of the compound represented by Formula 1 based on 100 parts by weight of the metal oxide nanoparticles, preferably 350 to 600 parts by weight of ultrapure water and 400 to 1,200 parts by weight of the compound based on 100 parts by weight of the metal oxide nanoparticles, and more preferably 350 to 550 parts by weight of ultrapure water and 450 to 850 parts by weight of the compound based on 100 parts by weight of the metal oxide nanoparticles. In this case, if the amount of ultrapure water is less than 100 parts by weight, there may be a problem in that the reflux of the solvent is not sufficiently performed during the surface modification process and thus the surface modification is not evenly performed, and if the amount of ultrapure water is more than 700 parts by weight, there may be a problem in that the reflux reaction time is too long. And, if the amount of the compound is less than 300 parts by weight, there may be a problem in that the degree of modification of the metal oxide surface is excessively insufficient or uneven to cause the metal oxide particles to be precipitated without being evenly dispersed in a solvent, and if the amount of the compound is more than 1,500 parts by weight, there may be a problem in that it is not economical, and rather, the device characteristics of the solar cell are deteriorated due to the unreacted compound, it is preferable to use it within the above range.

The reflux reaction in step second-3 can be performed at 80 to 140 °C, preferably at 80 to 120 °C, and in this case, if the reflux reaction temperature is less than 80 °C, there may be a problem in that reflux is not sufficiently performed, and if the reflux reaction temperature is greater than 140 °C, there may be a problem in that the metal oxide surface is too much modified to inhibit driving of the solar cell device. Further, the reflux reaction time is appropriately about 1 to 4 hours, preferably about 1.5 to 3 hours.

The separating and/or washing of step second-4 may be performed by a general method used in the art, and in one embodiment, the separating and/or washing may be performed by performing centrifugation to obtain a reflux reaction product from a reaction solution, and then washing it with ultrapure water or the like.

The drying of steps 2-5 may be performed by a general method used in the art, and in one embodiment, the reaction product obtained by washing may be performed by applying heat in an oven at 50 to 80 °C.

The above-described coating agent for forming the electron transporting layer of the present invention may be coated by a general coating method such as spin coating, blade coating, bar coating, spray coating, gravure coating, die coating, etc., and in one embodiment, after coating, an ultra-thin film having a thickness of 100 nm or less, preferably 1 to 40 nm, more preferably 1 to 20 nm may be formed by heat treatment at 200 °C or less.

Such a coating agent of the present invention may be used to manufacture an inverted or fin structured perovskite solar cell as follows.

The inverted perovskite solar cell of the present invention may be a solar cell having a structure in which a conductive substrate, a drain electrode, a hole transport layer (HTL), a light absorption layer (or a photoactive layer), an electron transporting layer (or an electron transport layer, ETL), and a source electrode are sequentially stacked.

In addition, the inverted perovskite solar cell of the present invention may be formed by sequentially stacking a conductive substrate, a drain electrode, a hole transport layer, a light absorption layer, an electron transporting layer, and a source electrode to form one set, and stacking the set in a single layer or multiple layers.

The conductive substrate may use a general conductive substrate used in the art, and for example, a transparent plastic substrate, a glass substrate, a quartz substrate, a silicon substrate, or the like made of a material such as polyethylene terephthalate, polyethylene naphthalate, polyethersulfone, aromatic polyester, or polyimide may be used.

The drain electrode may be made of a material including at least one selected from a conductive metal, an alloy of a conductive metal, a metal oxide, and a conductive polymer, and for example, preferably may include Indium Tin Oxide (ITO), Fluorine doped Tin Oxide (FTO), Sb₂O₃ doped Tin Oxide (ATO), Gallium doped Tin Oxide (GTO), tin doped zinc oxide (ZTO), ZTO:Ga (gallium doped ZTO), Indium gallium zinc oxide (IGZO), Indium doped zinc oxide (IZO), Aluminum doped zinc oxide (AZO), and/or the like.

In addition, the hole transport layer (HTL) may include an inorganic and/or organic hole transfer material. The inorganic hole transfer material may include at least one selected from nickel oxide (NiOx), CuSCN, CuCrO₂, and CuI.

The organic hole transfer material may include carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives, aromatic tertiary amine compounds, styrylamine compounds, aromatic dimethylidine-based compounds, porphyrin-based compounds, phthalocyanine-based compounds, polythiophene derivatives, polypyrrole derivatives, polyparaphenylenevinylene derivatives, pentacene, coumarin 6,3-(2-benzothiazolyl)-7-(diethylamino)coumarin, ZnPC (zinc phthalocyanine), CuPC (copper phthalocyanine), TiOPC (titanium oxide phthalocyanine), Spiro-MeOTAD(2,2' ,7,7'-tetrakis(N,N-p-dimethoxyphenylamino)-9,9'-spirobifluor ene), F16CuPC(copper(II) 1,2,3,4,8,9,10,11,15,16,17,18,22,23,24,25-hexadecafluoro-29H,31H-phthalocyani ne), SubPc(boron subphthalocyanine chloride) and N3(cis-di(thiocyanato)-bis(2,2'-bipyridyl-4,4'-dicarboxylic acid)-ruthenium(II), P3HT(poly[3-hexylthiophene]), MDMO-PPV(poly[2-methoxy-5-(3' ,7'-dimethyloctyloxyl)]-1,4-phenylene vinylene), MEH-PPV(poly[2-methoxy-5-(2"-ethylhexyloxy)-p-phenylene vinylene]), P3OT(poly(3-octyl thiophene)), POT(poly(octyl thiophene)), P3DT(poly(3-decyl thiophene)), P3DDT(poly(3-dodecyl thiophene), PPV(poly(p-phenylene vinylene)), TFB(poly(9,9'-dioctylfluorene-co-N-(4-butylphenyl)diphenyl amine), polyaniline, Spiro-MeOTAD([2,22',7,77'-tetrkis (N,N-di-pmethoxyphenyl amine)-9,9,9'-spirobi fluorine]), CuSCN, CuI, PCPDTBT(Poly[2,1,3-benzothiadiazole-4,7-diyl[4,4-bis(2-ethylhexyl-4H-cyclopen ta [2,1-b:3,4-b']dithiophene-2,6-diyl]], Si-PCPDTBT(poly[(4,4' -bis(2-ethylhexyl)dithieno[3,2-b:2',3'-d]silole)-2,6-di yl-alt-(2,1,3-benzothiadiazole)-4,7-diyl]), PBDTTPD(poly((4,8-diethylhexyloxyl), PFDTBT(poly[2,7-(9-(2-ethylhexyl)-9-hexyl-fluorene)-alt-5,5-(4' ,7-di-2-thieny 1-2',1',3'-benzothiadiazole)]), PFO-DBT(poly[2,7-.9,9-(dioctyl-fluorene)-alt-5,5-(4' ,7'-di-2-thienyl-2', 1',3'-benzothiadiazole)]), PSiFDTBT(poly[(2,7-dioctylsilafluorene)-2,7-diyl-alt-(4,7-bis(2-thienyl)-2,1, 3-benzothiadiazole)-5,5'-diyl]), PCDTBT(Poly [[9-(1-octylnonyl)-9H-carbazole-2,7-diyl] -2,5-thiophenediyl-2,1,3-benzothiadiazole-4,7-diyl-2,5-thiophenediyl]), PFB(poly(9,9'-dioctylfluorene-co-bis(N,N'-(4,butylphenyl))bis(N,N'-phenyl-1,4 -phenylene)diamine), F8BT(poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, and/or MeO-2PACz.

Further, the method of forming the hole transport layer may include a coating method, a vacuum deposition method, and the like, and the coat ing method may include a gravure coat ing method, a bar coat ing method, a print ing method, a spraying method, a spin coating method, a dip coating method, a die coating method, and the like.

In addition, the light absorption layer of the present invention solar cell configuration may include generally a perovskite material applied to the light absorption layer of the solar cell, and preferably, for example, may include a perovskite material represented by the following Formula 2.

### [Formula 2]

### CMX₃

In Formula 2, C is a monovalent cation and may include an amine, an ammonium, a Group 1 metal, a Group 2 metal, and/or other cation or cation-like compounds, and preferably, formamidinium (FA), methylammonium (MA), FAMA, CsFAMA or N(R)₄⁺ (where R may be the same or different groups, and R is a linear alkyl group having 1 to 5 carbon atoms, a branched alkyl group having 3 to 5 carbon atoms, a phenyl group, an alkylphenyl group, an alkoxyphenyl group or an alkylhalide).

In addition, M of Formula 2 is a divalent cation and may include one or two selected from Fe, Co, Ni, Cu, Sn, Pb, Bi, Ge, Ti, Eu and Zr.

In addition, X of Formula 2 is a monovalent anion and may include at least one halide element selected from F, Cl, Br and I and/or a Group 16 anion, and as a preferred example, X may be IₓBr₃₋ₓ (0 ≤ x ≤ 3).

In addition, in one embodiment, the Formula 2 may be, for example, FAPbIₓBr₃₋ₓ (0 ≤ x ≤ 3), MAPbIₓBr₃₋ₓ (0 ≤ x ≤ 3), CSMAFAPbIₓBr₃₋ₓ (0 ≤ x ≤ 3), CH₃NH₃PbX₃ (X= Cl, Br, I, BrI₂, or Br₂I), CH₃NH₃SnX₃ (X= Cl, Br or I), CH(=NH)NH₃PbX₃ (X= Cl, Br, I, BrIz, or Br₂I), CH(=NH)NH₃SnX₃ (X= Cl, Br or I), and the like.

In the solar cell of the present invention, the light absorption layer may be a single layer formed of the same perovskite material or may be a multilayer structure in which a plurality of layers formed of different perovskite materials are stacked, and may include a different perovskite material different from the perovskite material having a pillar shape such as a column shape, a plate shape, a needle shape, a wire shape, and a rod shape in the light absorption layer formed of one perovskite material.

In the solar cell configuration of the present invention, the electron transporting layer may be formed on the top of light absorption layer by coating the coating solution of the above-described coating agent (dispersion liquid in which the surface-modified metal oxide nanoparticles are dispersed in an organic solvent) and then performing a low-temperature heat treatment at 200 °C or less, preferably 30 to 100 °C or less to form a thin film-shaped coating layer.

In this case, the coating may be performed by spin coating, blade coating, bar coating, spray coating, gravure coating or die coating.

In addition, the thickness of the electron transporting layer may be 100 nm or less, preferably 1 to 40 nm, more preferably 1 to 20 nm, and in this case, if the thickness of the electron transporting layer exceeds 100 nm, there may be a problem in that a short-circuit current (Jsc) and an open-circuit voltage (Voc) of the solar cell decrease, and thus the thickness may be formed within the above range.

The roughness of the thus-formed coating layer, that is, the surface of the electron transporting layer may be formed to be very low, and the root-mean-square (RMS) roughness may be 30 nm or less, preferably 17.0 to 25.0 nm, more preferably 17.5 to 24.0 nm.

In addition, the source electrode of the solar cell configuration of the present invention may be formed by coating or depositing at least one material selected from Pt, Au, Ni, Cu, Ag, In, Ru, Pd, Rh, Ir, Os, C and a conductive polymer.

In addition, the solar cell of the present invention may further include a passivation layer between the light absorption layer and the electron transporting layer.

Hereinafter, the present invent ion will be described in more detail through the following examples, but the following examples are not intended to limit the scope of the present invention, which should be construed to aid understanding of the present invention.

### [Examples]

### Example 1: Preparation of a coating solution for forming an electron transporting layer (ETL)

### (1) Preparation of SnO₂ nanoparticles

SnCl₄·5H₂O was added to a beaker containing ultrapure water and stirred to prepare a metal precursor solution having a SnCl₄ concentration of 0.33 M, and then 35 ml of a basic aqueous solution NH₄OH was added to 265 ml of the metal precursor solution to prepare a reaction solution having a pH of about 8.0 to 8.5 of the aqueous solution.

The reactive solution was put into a pressure vessel (autoclave or hydrothermal reactor) and hydrothermal synthesis was performed at 180 °C for 12 hours.

Next, the product obtained through hydrothermal synthesis was washed three to five times using ultrapure water and ethanol to prepare SnO₂ nanoparticles.

The average particle diameter of the prepared SnO₂ nanoparticles was 3 to 5 nm.

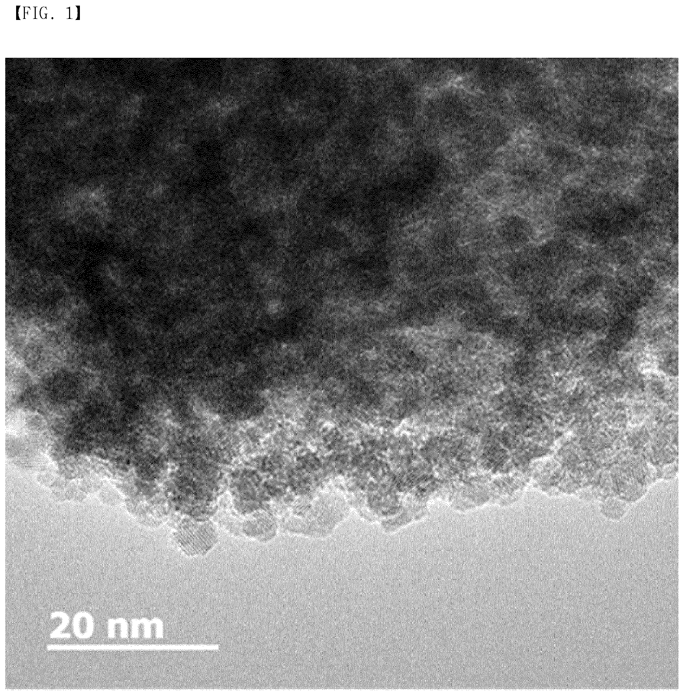

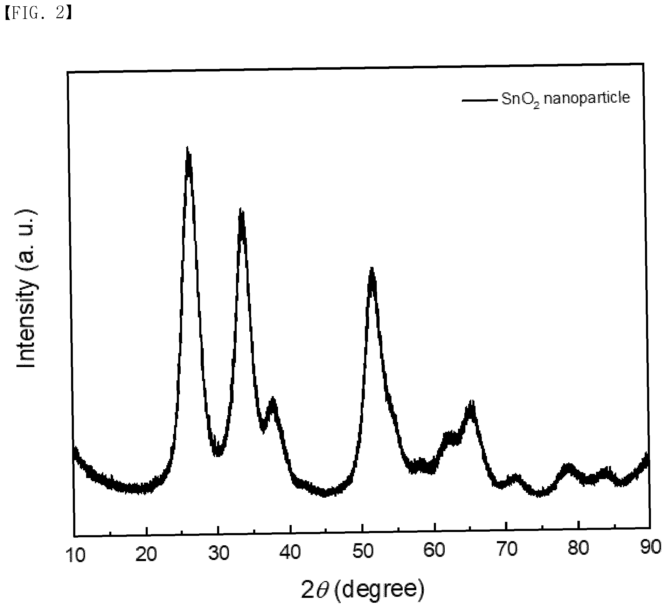

Further, TEM measurement images of the prepared SnO₂ nanoparticles are shown in FIG. 1, and XRD measurement results are shown in FIG. 2.

### (2) Preparation of surface-modified SnO₂ nanoparticles

8 g of the previously prepared SnO₂ nanoparticles were added to a round bottom flask containing 40 mL of ultrapure water and stirred, and then 54 g of TFA (trifluoroacetic acid) was added to prepare a reaction solution. A condenser was mounted on a round bottom flask containing the prepared reaction solution, and a reflux reaction was performed at 90 °C for 2 hours.

Next, the nanoparticles were separated from the reaction solution subjected to the reflux reaction by using a centrifuge and then dried in an oven at 60 °C to prepare surface-modified SnOz nanoparticles.

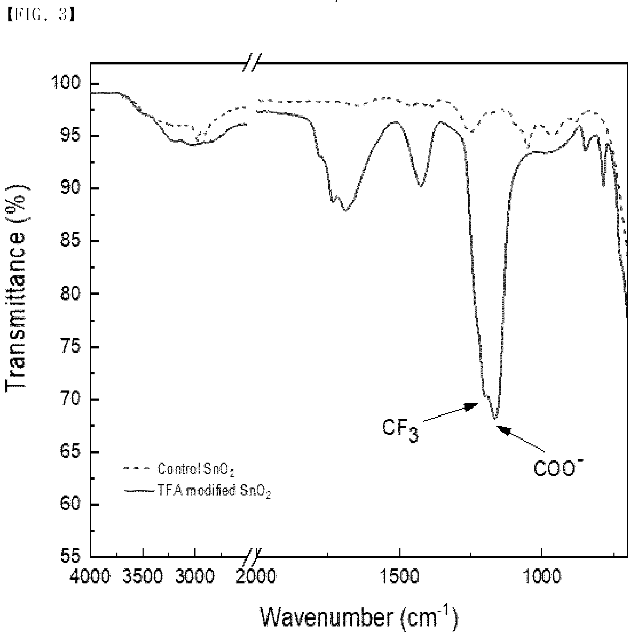

Further, FT-IR measurement results of the prepared surface-modified SnO₂ nanoparticles are shown in FIG. 3.

### (3) Preparation of a dispersion solution (coating solution) of surface-modified SnO₂ nanoparticles

30 mg of the previously prepared surface-modified SnO₂ nanoparticles were added to 4 ml of low polarity isopropyl alcohol (dielectric constant ≤ 20), and then a coating solution for forming an electron transporting layer having a dispersion solution type (about 0.74 wt % of surface-modified metal oxide) was prepared using an ultrasonic crusher.

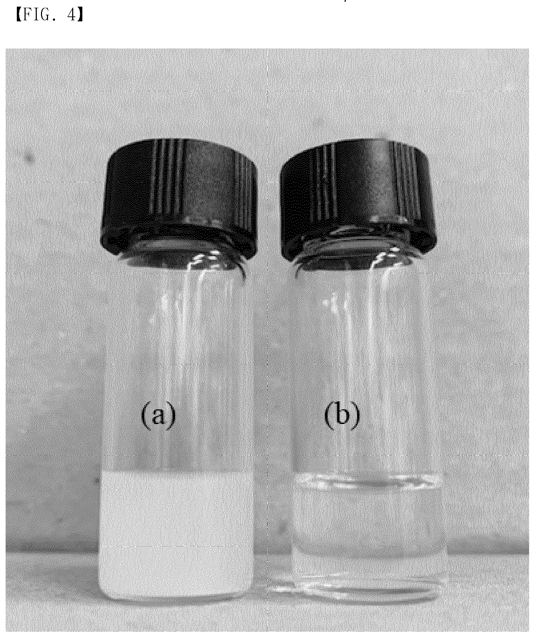

Further, a photograph of the coating solution for forming an electron transporting layer having a dispersion solution type is shown in FIG. 4(b), and FIG. 4(a) is a photograph after 30 mg of the surface-modified SnO₂ nanoparticles were added to isopropyl alcohol and dispersed using an ultrasonic crusher.

### Comparative Example 1

The SnO₂ nanoparticles prepared in (1) of Example 1 were prepared without a surface modification process.

Further, 30 mg of the SnO₂ nanoparticles without surface modification were added to 4 ml of isopropyl alcohol, and then a coating solution for forming an electron transporting layer having a dispersion solution type was prepared using an ultrasonic crusher. A photograph of the prepared coating solution is shown in FIG. 4(a).

### Examples 2 to 3 and Comparative Examples 2 to 3

Examples 2 to 3 and Comparative Examples 2 to 3 were performed by preparing a coating solution for forming an electron transporting layer in the same manner as in Example 1, except that surface-modified SnOz nanoparticles having a composition as shown in Table 1 below were prepared, the surface-modified SnO₂ nanoparticles were mixed with an organic solvent, and then a coating solution for forming an electron transporting layer of a dispersion solution type was prepared using an ultrasonic crusher, respectively.

### Comparative Example 4

Comparative Example 4 was performed by preparing a coating solution for forming an electron transporting layer in the same manner as in Example 1, except that the surface-modified SnO₂ nanoparticles of Example 1 were mixed with ethyl alcohol having a dielectric constant of 25, and then a coating solution for forming an electron transporting layer of a dispersion solution type was prepared using an ultrasonic crusher, respectively.

**[Table 1]**

| Classification | Surface-modified SnO₂ nanoparticles | | | | Organic solvent |
|---|---|---|---|---|---|
| | SnO₂ nanoparticles | | Ultrapure water | TFA | |
| | Amount used | Average particle diameter | Amount used | Amount used | |
| Example 1 | 100 parts by weight (8g) | 3 - 5 nm | 500 parts by weight (40ml) | 675 parts by weight (54g) | Isopropyl alcohol |
| Example 2 | 100 parts by weight | 3 - 5 nm | 500 parts by weight | 350 parts by weight | Isopropyl alcohol |
| Example 3 | 100 parts by weight | 3 - 5 nm | 500 parts by weight | 1,350 parts by weight | Isopropyl alcohol |
| Comparative Example 1 | 100 parts by weight | 3 - 5 nm | - | - | Isopropyl alcohol |
| Comparative Example 2 | 100 parts by weight | 3 - 5 nm | 500 parts by weight | 270 parts by weight | Isopropyl alcohol |
| Comparative Example 3 | 100 parts by weight | 3 - 5 nm | 500 parts by weight | 1570 parts by weight | Isopropyl alcohol |
| Comparative Example 4 | 100 parts by weight | 3 - 5 nm | 500 parts by weight | 675 parts by weight | Ethyl alcohol |

### Experimental Example 1: Ultra-thin film preparation and coating layer surface roughness and light transmittance measurement

Each of the coating solutions prepared in the Examples and Comparative Examples was spin-coated on the top of a perovskite thin film including a glass substrate and a glass substrate, and then heat-treated at 30 °C , thereby preparing an ultra-thin film having a thickness of 20 nm.

In addition, the surface roughness of the ultra-thin film formed on the top of the perovskite thin film including the glass substrate was measured by a non-contact method, and then calculated as root-mean-square (RMS) of the roughness, and the surface roughness of any 3 points was measured, and then the average value of the measured surface roughness of the 3 points is shown in Table 2 below.

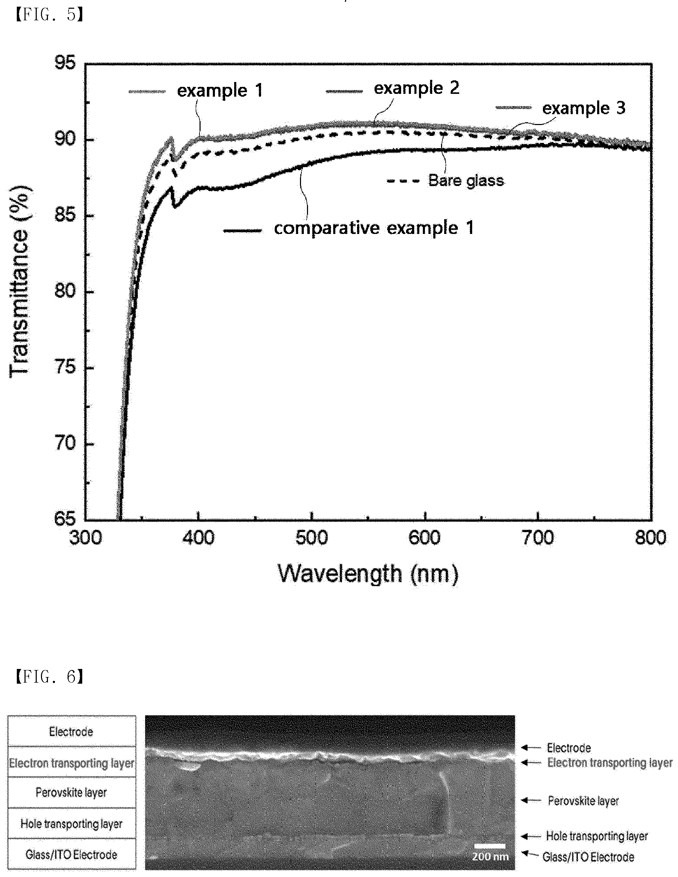

In addition, the ultra-thin film formed on the glass substrate was scanned with near-infrared rays by a UV spectrum measurement method onto the substrate on which the ultra-thin film was formed to measure the absorbance and light transmittance (%) of the sample, and the results are shown in Table 2 below, and the results of measuring the light transmittance of Example 1 are shown in FIG. 5. In this case, the light transmittance is a light transmittance at a wavelength of 500 to 550 nm.

**[Table 2]**

| Classification | RMS (root-mean-square) roughness | Light transmittance (%) |
|---|---|---|
| Example 1 | 19.8 nm | 91.1% |
| Example 2 | 21.5 nm | 90.9% |
| Example 3 | 22.7 nm | 91.0% |
| Comparative Example 1 | 71.4 nm | 88.9% |
| Comparative Example 2 | 35.7 nm | 89.3% |
| Comparative Example 3 | 24.8 nm | 90.2% |
| Comparative Example 4 | Not measurable | Not measurable |

Referring to the RMS roughness and the light transmittance of Table 2, it was confirmed that in the case of Examples 1 to 3, the RMS roughness was 18.0 to 23.0 nm, which was very low, and excellent optical properties of light transmittance of 90% or more were achieved.

On the other hand, in the case of Comparative Example 2, which is a coating solution using surface-modified SnO₂ nanoparticles prepared using only 270 parts by weight of less than 300 parts by weight of TFA when synthesizing surface-modified SnO₂ nanoparticles, compared to Example 1 or Example 2, there was a problem that not only the light transmittance was low, but also the roughness was relatively high, and in the case of Comparative Example 3, which uses 1570 parts by weight of more than 1500 parts by weight of TFA, compared to Example 3, there was a part where the roughness increased and the light transmittance was partially lowered, which is considered to be due to agglomeration between some of the surface-modified SnO₂ nanoparticles.

And, in the case of Comparative Example 4, there was a problem in that since the SnO₂ particles were not dispersed, the agglomerated particles were coated in the form of islands on top of the glass substrate, so that a thin film could not be formed.

### Preparing Example 1: Preparation of an inverted perovskite solar cell to which surface-modified SnO₂ nanoparticles are applied

As a drain electrode, an organic substrate (thickness 1.1 mm, 15.0 Ω/sq) coated with indium tin oxide (ITO) having a thickness of about 110 nm was sequentially washed with acetone and isopropyl alcohol (IPA) by using an ultrasonic cleaner for 1 hour, respectively.

Next, a hole transport layer (NiOₓ) having a thickness of 30 nm was formed on the ITO substrate under the conditions of an E-beam vacuum deposition method.

Next, a yellow light absorption layer solution formed by dissolving in dimethylformamide (DMF) and dimethyl sulfoxide (DMSO) was formed on the top of the hole transport layer by spin coating, and heat-treated at 100 °C for 20 minutes to form a NiOx hole transport layer and a light absorption layer (CSMAFAPbIₓBr₃₋ₓ (0 ≤ x ≤ 3)) having a perovskite crystal structure of 450 to 500 nm thick.

Next, a passivation layer (C₆₀ fullerene) having a thickness of 13 nm was formed on the top of the light absorption layer under the conditions of thermal evaporation.

Next, the surface-modified coating solution prepared in Example 1 was spin-coated on the top of the passivation layer at 1,500 rpm for 1 minute, and then heat-treated at 30 °C to form an electron transporting layer having a thickness of 20 nm.

Next, silver (Ag) was deposited on the top of the electron transporting layer to a thickness of 150 nm at a pressure of 1 × 10⁻⁸ torr to form a source electrode, thereby preparing an inverted perovskite solar cell.

And, the SEM measurement image of the prepared solar cell is shown in FIG. 6.

### Preparing Examples 2-3 and Comparative Preparing Examples 1-3

Preparing Examples 2 to 3 and Comparative Preparing Examples 1 to 3 were each performed, by preparing the inverted perovskite solar cells in the same manner as in Preparing Example 1, except that each of the solar cells in which the electron transporting layer was formed was prepared using the coating agents of Examples 2 to 3 and Comparative Examples 1 to 3 instead of the coating agent of Example 1.

### Experimental Example 2: Performance measurement of a solar cell

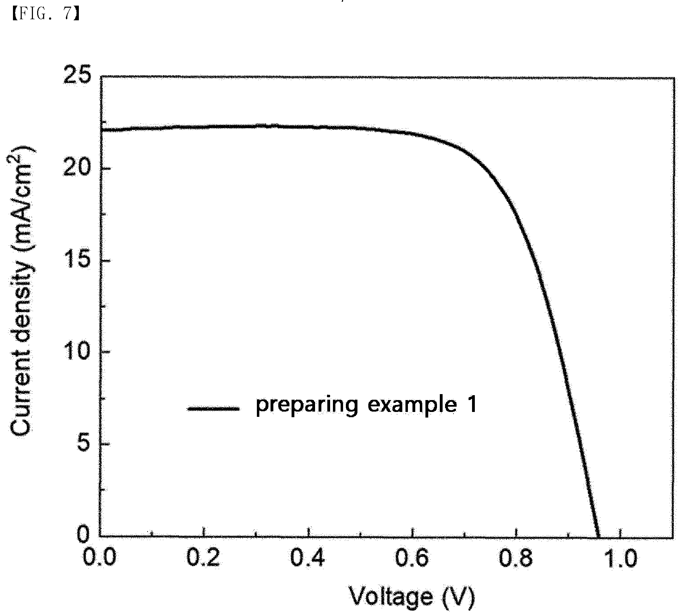

The current-voltage characteristics and efficiency of the solar cell prepared in Preparing Example 1 were measured, and the results are shown in Table 3 below. In addition, the measurement results of the short-circuit current density for Preparing Example 1 are shown in FIG. 7.

**[Table 3]**

| Classificatio n | Electron transport in g layer | Open-circui t voltage (V_{oc}, V) | Short-circui t current density (J_{sc}, mA/cm²) | Fill facto r (FF) | Photoelectri c conversion efficiency (%) |
|---|---|---|---|---|---|
| Preparing Example 1 | Example 1 | 0.958 | 22.08 | 69.98 | 14.81 |
| Preparing Example 2 | Example 2 | 0.939 | 21.87 | 67.47 | 13.86 |
| Preparing Example 3 | Example 3 | 0.889 | 21.34 | 56.01 | 10.63 |
| Comparative | Comparative | 0.755 | 12.71 | 33.14 | 3.18 |
| Preparing Example 1 | Example 1 | | | | |

Referring to the current-voltage characteristics and efficiency measurement results of the solar cells of Table 3 and FIG. 7, it can be confirmed that they have a very high fill factor and photoelectric conversion efficiency.

## Claims

1. A coating agent for an electron transporting layer of an inverted perovskite solar cell, the coating agent comprising:
a dispersion in which a surface-modified metal oxide is dispersed in an organic solvent,
wherein the organic solvent has a dielectric constant of 20 or less.

2. The coating agent for an electron transporting layer of an inverted perovskite solar cell of claim 1, wherein the coating agent comprises 0.50 wt % to 3.00 wt % of surface-modified metal oxide and a balance of an organic solvent.

3. The coating agent for an electron transporting layer of an inverted perovskite solar cell of claim 1, wherein the organic solvent comprises at least one selected from isopropyl alcohol, butyl alcohol, 2-methoxy ethanol, and ethyl acetate.

4. The coating agent for an electron transporting layer of an inverted perovskite solar cell of claim 1, wherein the surface-modified metal oxide is surface-modified by reacting metal oxide nanoparticles with a compound represented by the following Formula 1: 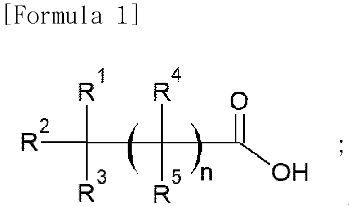 wherein R¹ to R⁵ in Formula 1 are independently a hydrogen atom or a halogen atom, and n is 0 to 5.

5. The coating agent for an electron transporting layer of an inverted perovskite solar cell of claim 4, wherein the metal oxide nanoparticles comprise a metal oxide comprising one or two or more selected from tin (Sn), zirconium (Zr), strontium (Sr), zinc (Zn), vanadium (V), molybdenum (Mo), tungsten (W), niobium (Nb), aluminum (Al), and gallium (Ga).

6. The coating agent for an electron transporting layer of an inverted perovskite solar cell of claim 4, wherein the metal oxide nanoparticles have an average particle diameter of 2 to 10 nm.

7. An electron transporting layer of an inverted perovskite solar cell comprising a coating layer formed by the coating agent of any one of claims 1 to 7.

8. The electron transporting layer of an inverted perovskite solar cell of claim 7, wherein the coating layer has a transmittance of 88 to 95% for a wavelength of 500 to 550 nm when the coating layer has a thickness of 20 to 30 nm.

9. An inverted perovskite solar cell comprising the electron transporting layer of claim 7.

10. The inverted perovskite solar cell of claim 9, wherein the inverted perovskite solar cell comprises a structure in which a conductive substrate, a drain electrode, a hole transport layer, a light absorption layer, an electron transporting layer, and a source electrode are sequentially stacked.

11. The inverted perovskite solar cell of claim 10, further comprising a passivation layer between the light absorption layer and the electron transporting layer.
